# EUROPÄISCHE PATENTSCHRIFT

(11) **EP 0 976 146 B1**
(45) Veröffentlichungstag und Bekanntmachung des Hinweises auf die Patenterteilung: **10.07.2002**
(21) Anmeldenummer: 98921450.7
(22) Anmeldetag: 09.04.1998
(51) Int. Cl.: H01L 21/00

(54) **VORRICHTUNG ZUM BEWEGEN VON SUBSTRATEN DURCH EINE SUBSTRAT-BEHANDLUNGSEINRICHTUNG**
DEVICE FOR CONVEYING SUBSTRATES THROUGH A SUBSTRATE PROCESSING PLANT
DISPOSITIF DE TRANSPORT DE SUBSTRATS A TRAVERS UNE INSTALLATION DE TRAITEMENT DE SUBSTRATS

(30) Priorität: 17.04.1997 DE 19716123
(43) Veröffentlichungstag der Anmeldung: 02.02.2000
(73) Patentinhaber: Steag HamaTech AG, 75447 Sternenfels (DE)
(72) Erfinder: WEBER, Klaus, D-75015 Bretten (DE); MAHNER, Bernd, D-75417 Mühlacker (DE)
(74) Vertreter: Wagner, Karl H., Dipl.-Ing.
(86) Internationale Anmeldenummer: EP9802083
(87) Internationale Veröffentlichungsnummer: WO9848450

(56) Entgegenhaltungen:
- US-A- 4 217 977
- US-A- 4 938 649
- US-A- 5 611 858

## Beschreibung

Die Erfindung betrifft eine Vorrichtung zum Bewegen von Substraten durch eine Substrat-Behandlungseinrichtung.

Vorrichtungen dieser Art sind zum Bewegen von Substraten, insbesondere von CD's, durch Kühlungs- und Trocknungseinrichtungen bekannt. Die Substrate befinden sich dabei in auf einer Kreisbahn bewegten Körben oder in entsprechenden in kreisförmigen Einrichtungen ausgebildeten Schlitzen. Derartige Karussell-Transporteinrichtungen weisen jedoch große Abmessungen auf und benötigen große Antriebseinrichtungen, so daß derartige bekannte Einrichtungen kostenintensiv sind. Darüber hinaus ist das Beschicken einer derartigen Karussell-Transporteinrichtung mit Substraten bzw. deren Entnahme schwierig und mit hohem konstruktiven Aufwand verbunden.

Für Vorrichtungen der eingangsgenannten Art ist es auch bekannt, eine Schnecken-Welle einzusetzen, die sich dreht und die in den Schneckengängen liegenden Substrate dabei vorwärts bewegt. Dies hat jedoch den Nachteil, daß eine Relativbewegung zwischen der Schnecken-Welle und den Substraten und damit eine Reibung auftritt, die einen Abrieb verursacht und zu Kontaminationen führt.

Aus der DE 43 41 634 A1, von der die vorliegende Erfindung ausgeht, ist eine Vorrichtung für den Transport von scheibenförmigen Substraten in einer Substrat-Behandungseinrichtung bekannt, bei der drei Zahnriemen vorgesehen sind, mit denen die Substrate durch eine Behandlungseinrichtung transportiert werden. Diese Vorrichtung ist jeweils nur für eine Substratform und -größe konzipiert und läßt sich nicht an sich ändernde Gegebenheiten, wie beispielsweise unterschiedliche Substratgrößen anpassen.

Aus der US-A-4 938 649 ist außerdem eine Vorrichtung für den Transport von scheiben förmigen Substraten bekannt, bei der drei seiten vorgesehen sind, mit denen die Substrate transportiert werden. Der Abstand der seiten zueinander ist veränderbar.

Aus der US 4 947 784 ist eine Vorrichtung zum Umsetzen von Wafern aus einer ersten Waferhalterung (Waferkassette) in eine zweite Waferhalterung (Wafer-Boat) bekannt. Ein derartiger, sogenannter Handler für Wafer ist für den Transport der Wafer durch eine Behandlungseinrichtung weder vorgesehen noch geeignet.

Aus der DE 195 30 858 C1 ist ebenfalls ein Handler bekannt, bei der die Wafer mittels einer Ansaugplatte transportiert werden. Bei dem aus der DE 195 29 945 A1 bekannten Handler erfolgt das Greifen und Halten eines flachen Substrats mittels eines Innengreifers, bei dem der Greifer in ein im Inneren des Substrats ausgebildetes Loch eingreift und sich am Innenloch-Rand abstützt.

Der Erfindung liegt die Aufgabe zugrunde, eine aus der DE 43 41 634 A1 bekannte Vorrichtung derart weiter zu bilden, daß eine Anpassung der Vorrichtung an unterschiedliche Gegebenheiten, beispielsweise unterschiedliche Substratgrößen auf einfache Weise möglich ist.

Die gestellte Aufgabe wird erfindungsgemäß durch die kennzeichnenden Merkmale des Anspruchs 1 gelöst. Durch den veränderbaren Abstand der seitlichen Transportbänder zueinander und/oder zum Basistransportband ist nicht nur eine Anpassung der Vorrichtung an die jeweiligen Gegebenheiten, insbesondere an unterschiedliche Substratgrößen, sondern auch ein Nachjustieren der für das zuverlässige Halten und Transportieren der Substrate wichtigen Abstände auf einfache Weise möglich.

Außerdem ist der Winkel zwischen den Transportebenen der beiden seitlichen Transporbänder und der Transportebene des Basistransportband veränderbar. Auf diese Weise läßt sich eine optimale Einstellung der Stützstellen der in den Transportbändern transportierten Substrate erreichen. Darüberhinaus ist es auch möglich, die Vorrichtung mit einfachen Mitteln an unterschiedliche Substrat-Formen oder -Maße anzupassen, seien sie rund oder rechteckig. Bei rechteckigen Substraten wird der Winkel zwischen den Transportebenen der seitlichen Transportbänder und der Transportebene des Basisteransportbands vorzugsweise auf 90° eingestellt.

Der Erfindung liegt daher die Aufgabe zugrunde, eine Vorrichtung zum Bewegen von Substraten durch eine Substrat-Behandlungseinrichtung zu schaffen, mit der eine karussellartige, auf einer Kreisbahn erfolgende Bewegung der Substrate oder ein Substratabrieb vermieden und eine konstruktiv einfache, platzsparende und leicht handhabbare Vorrichtung ermöglicht wird.

Die gestellte Aufgabe wird erfindungsgemäß durch ein Basis-Transportband und zwei seitliche Transportbänder gelöst, die jeweils Einschnitte zur senkrechten Aufnahme der Substrate aufweisen. Auf Grund der Merkmale, drei Transportbänder zu verwenden, ergibt sich eine lineare Bewegung der Substrate mit dem Vorteil, daß die Vorrichtung sehr einfach, raumsparend und abriebfrei ist und darüber hinaus auch leicht an die jeweiligen Gegebenheiten, beispielsweise an die Größe der Substrate, angepaßt werden kann.

Gemäß einer besonders vorteilhaften Ausführungsform der Erfindung sind die Einschnitte zur senkrechten Aufnahme der Substrate die Zwischenräume von Zähnen eines als Zahnriemen ausgebildeten Transportbands. Derartige Zahnriemen sind kostengünstig herstellbar.

Zur Anpassung der erfindungsgemäßen Transportvorrichtung ist der Abstand der seitlichen Transportbänder zum Basisband veränderlich. Durch die Einstellung des Abstandes der seitlichen Transportbänder zum Basisband ist also auf einfache Weise eine Anpassung der Vorrichtung an unterschiedliche Substrat-Größen möglich.

Im Falle, daß es sich um runde Substrate, wie beispielsweise CD's oder DVD's handelt, ist es besonders vorteilhaft, wenn die Transportebenen der beiden seitlichen Transportbänder auf einen Winkel größer als 90° zur Transportebene des Basistransportbands eingestellt werden. Dadurch ist ein einfaches Einsetzen und Herausnehmen der Substrate aus der erfindungsgemäßen Transportvorrichtung möglich, wobei dennoch die Lagerung der Substrate in der Transportvorrichtung sicher und zuverlässig bleibt.

Die Transportbänder sind vorzugswiese jeweils über Umlenk- und Antriebsräder geführt, die insbesondere auch Zahnräder sein können, wenn die Transportbänder oder wenigstens eines der Transporbänder auf der der Transportfläche abgewandten Seite, also der Antriebsseite, als Zahnriemen ausgebildet sind bzw. ist. Eine beidseitige Zahnriemenausbildung der Transportbänder ist daher sehr vorteilhaft.

Eine sehr vorteilhafte Ausführungsform der Erfindung besteht darin, daß jeder der drei Transportbänder in einer eigenen Transportbandeinrichtung geführt und mit einem eigenen Antrieb angetrieben ist. Auf diese Weise sind die einzelnen Transportbandeinheiten selbständige Einheiten, wodurch die Anordnung, Anpassung und Ausrichtung der Transportbänder an unterschiedliche Substrate möglich ist.

Sehr vorteilhaft ist eine Ausführungsform, bei der die Antriebe der drei Transportbänder zueinander synchron gesteuert sind. Dadurch ergibt sich nicht nur eine gleiche Antriebsgeschwindigkeit für alle drei Transportbänder, sondern auch eine synchrone Ausrichtung der Einschnitte zur Aufnahme der Substrate. Statt der synchronen Steuerung ist es auch möglich, die Antriebe der drei Transporteinrichtungen bzw. die drei Transportbänder über ein gemeinsames Getriebe, vorzugsweise ein spielloses Getriebe, vorzunehmen, um wiederum die synchrone Bewegung der drei Antriebsbänder bzw. deren Einschritte zur Aufnahnme der Substrate sicherzustellen. Das Getriebe kann dabei von einer allen Transportbändern gemeinsamen Antrieb angetrieben werden.

Die Transportbänder oder zumindest die Teile der Transportbänder, die mit den Substraten in Berührung stehen, bestehen vorzugsweise aus einem Spezialmaterial zur Vermeidung von Kontaminationen, insbesondere aus Teflon, oder einem Material, welches gegen die Aufnahme von Kontaminationen unempfindlich ist bzw. leicht gereinigt werden kann.

Zum Be- und/oder Entladen der erfindungsgemäßen Transportvorrichtung bzw. der drei Transportbänder mit bzw. von Substraten erfolgt vorzugsweises mit Sauggreifern und/oder Innengreifern, die am Rand des Innenlochs beispielsweise von CD's angreifen. Derartige Greifer sind einfach und verhindern die nachträgliche Kontamination der Substrate nach dem Behandlungsvorgang.

Die erfindungsgemäße Transportvorrichtung ist insbesondere im Zusammenhang mit Substrattrocknern oder -kühlern von besonderem Vorteil, die vor allem bei der Herstellung von CD's verwendet werden.

Unter Substrate sind alle scheibenartigen Behandlungsgegenstände zu verstehen, also nicht nur CD's einschließlich Audio-CD's, ROM-CD's, sogenannten recordable CD's (CDR's), Digital Video Disk's (DVD's) usw., sondern auch Masken zur Herstellung von Halbleiterbauelementen, Anzeigeeinrichtungen usw.

Die Erfindung wird nachfolgend anhand eines Ausführungsbeispiels unter Bezugnahme auf die Figuren erläutert. Es zeigen:
- Fig. 1: eine erfindungsgemäße Transportvorrichtung für eine Trocknungseinrichtung zum Trocknen von CD's in seitlicher Darstellung,
- Fig. 2: die in Fig. 1 dargestellte Vorrichtung in Aufsicht,

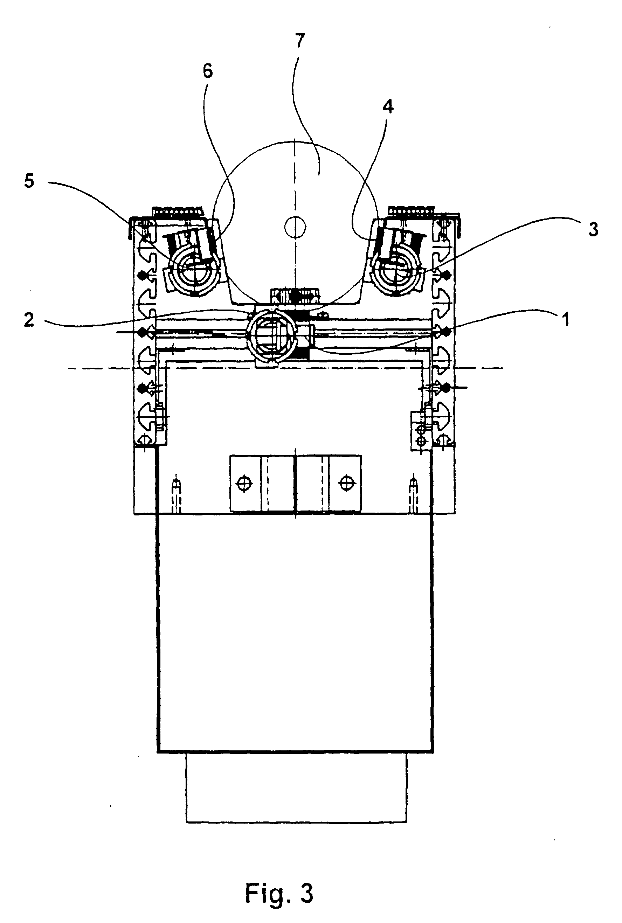

- Fig. 3: eine vergrößerte Schnittdarstellung entlang der in Fig. 1 eingezeichneten Schnittlinie III-III und
- Fig. 4: eine vergrößerte Schnittdarstellung entlang der in Fig. 1 gezeichneten Schnittlinie IV-IV.

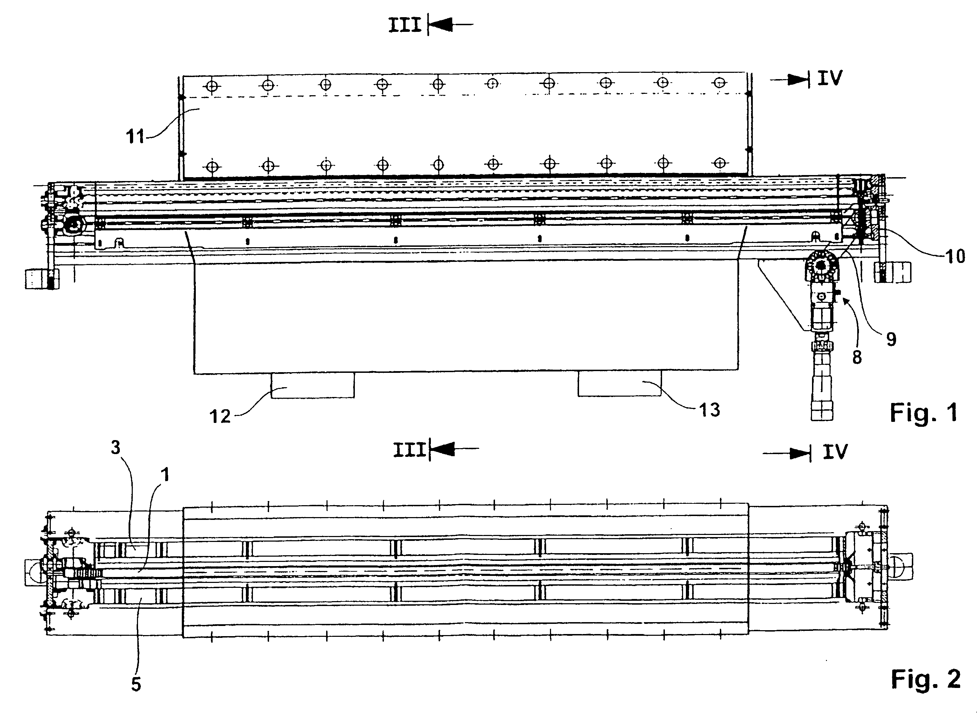

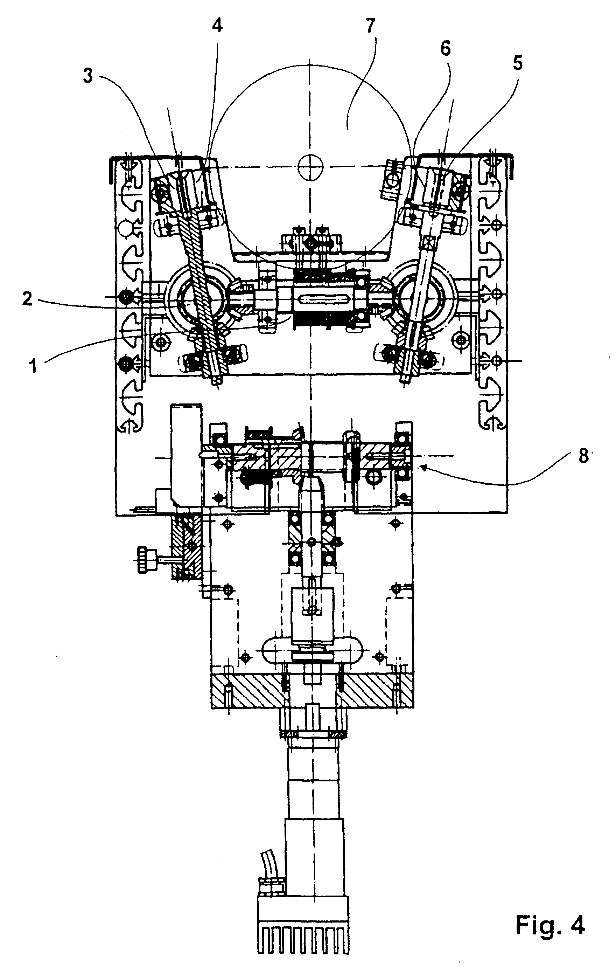

Wie die Figuren zeigen, weist die erfindungsgemäße Vorrichtung eine erste Transportbandeinrichtung 1 mit einem Basis-Transportband 2, eine zweite Transportband-Einrichtung 3 mit einem seitlichen Transportband 4 und eine dritte Transportbandeinrichtung 5 mit einem weiteren seitlichen Transportband 6 auf. Die Transportbänder 2, 4, 6 weisen zur Aufnahme der Substrate 7 Einschnitte bzw. Zwischenräumen von Zähnen eines Zahnriemens auf, die in allen drei Transportbändern ausgebildet sind. Wie insbesondere aus Fig. 1 und 4 ersichtlich ist, erfolgt der Antrieb der Transportbänder 2, 4, 6 mittels einer gemeinsamen Antriebseinrichtung 8, die über ein Antriebsband 9 ein Getriebe 10 antreibt, welches seinerseits die drei Transportbänder 2, 4, 6 synchron bewegt.

Bei der dargestellten Ausführungsform der erfindungsgemäßen Bewegungvorrichtung zum Trocknen der Substrate ist ein sich über einen großen Teil der Länge der Bewegungsvorrichtung erstreckendes Gebläse 11 vorgesehen, mit dem entweder die vom Gebläse 11 ewärmte oder von außen zugeführte erwärmte Luft auf die auf den Transportbändern 2, 4, 6 kontinuierlich oder schrittweise transportierte Substrate 7 zum Trocknen geblasen wird. Die verbrauchte Trocknungsluft wird aus dem Trocknungsgehäuse an den Autrittsöffnungen 11, 12 abgeleitet.

Die vorliegende Erfindung wurde anhand eines bevorzugten Ausführungsbeispiels erläutert. Dem Fachmann sind jedoch zahlreiche Abwandlungen und Ausgestaltungen möglich, ohne daß dadurch der Erfindungsgedanke verlassen wird. Beispielsweise sind die Transportbandeinheiten 1, 3, 5 unabhängig voneinander ausgebildet, so daß diese zueinander in ihrer Lage veränderbar sind, um dieselbe Transportvorrichtung für unterschiedliche Substrate 7 verwenden zu können. Beim dargestellten Ausführungsbeispiel ist das Substrat 7 rund und die seitlichen Transportbänder 4, 6 weisen zur Transportebene des Basistransportbands 2 einen Winkel auf, der größer als 90° ist, so daß das Substrat 7 an drei Stellen in der unteren Hälfte der Substratscheibe sicher gehalten ist. Für größere runde Substrate 7 werden die seitlichen Transportbandeinheiten 3, 5 lediglich weiter nach außen versetzt und gegebenenfalls der Winkel der seitlichen Transportbandeinheiten bezüglich des Basisbandes 2 verändert, um wiederum eine möglichst optimale Abstützung der Substrate zu gewährleisten. Im Falle eines quadratischen oder rechteckigen Substrats werden die seitlichen Transportbandeinrichtungen so angeordnet oder geschwenkt, daß die seitlichen Transportbänder 4, 6 senkrecht zur Transportebene des Basistransportbandes 2 ausgerichtet sind.

## Patentansprüche

1. Vorrichtung zum Bewegen von Substraten (7) durch eine Substrat-Behandlungseinrichtung (11) mit einem Basis-Transportband (2) und zwei seitlichen Transportbändern (4, 6), die jeweils Einschnitte zur senkrechten Aufnahme der Substrate (7) aufweisen, **dadurch gekennzeichnet, daß** der Abstand der seitlichen Transportbänder (4, 6) zueinander und/oder zum Basistransportband (2) veränderbar ist, und daß der Winkel zwischen der Transportebene wenigstens eines seitlichen Transportbandes (4, 6) und der Transportebene des Basistransportbands (2) veränderbar ist.

2. Vorrichtung nach Anspruch 1, **dadurch gekennzeichnet, daß** die Einschnitte Zwischenräume von Zahnriemen ausgebildeten Transportbändern (2, 4, 6) sind.

3. Vorrichtung nach einem der vorhergehenden Ansprüche, **dadurch gekennzeichnet, daß** die Transportebene der beiden seitlichen Transportbänder (4, 6) auf einen Winkel größer als 90° zur Transportebene des Basistransportbands (2) eingestellt werden können.

4. Vorrichtung nach einem der vorhergehenden Ansprüche, **dadurch gekennzeichnet, daß** die Transportbänder jeweils über Umlenk- und Antriebsräder oder -rollen geführt sind.

5. Vorrichtung nach einem der vorhergehenden Ansprüche, **dadurch gekennzeichnet, daß** jedes der drei Transportbänder (2, 4, 6) in einer eigenen Transportbandeinheit (1, 3, 5) geführt und mit einem eigenen Antrieb angetrieben ist.

6. Vorrichtung nach Anspruch 5, **dadurch gekennzeichnet, daß** die Antriebe der drei Transportbandeinheiten (2, 4, 6) zueinander synchron gesteuert sind.

7. Vorrichtung nach Anspruch 5, **dadurch gekennzeichnet, daß** die Antriebe der drei Transportbandeinheiten (1, 3, 5) über ein gemeinsames Getriebe (10) verbunden sind.

8. Vorrichtung nach einem der vorhergehenden Ansprüche, **dadurch gekennzeichnet, daß** wenigstens die Teile der Transportbänder (2, 4, 6), die mit den Substraten (7) in Berührung kommen, aus Teflon bestehen.

9. Vorrichtung nach einem der vorhergehnenden Ansprüche, **dadurch gekennzeichnet, daß** wenigstens ein Sauggreifer zum Be- und/oder Entladen der Substrate (7) vorgesehen ist.

10. Vorrichtung nach einem der vorhergehenden Ansprüche,
**dadurch gekennzeichnet, daß** wenigstens ein am Rand eines Innenloches von Substraten angreifende Greifer zum Be- und/oder Entladen der Substrate (7) vorgesehen ist.

11. Vorrichtung nach einem der vorhergehenden Ansprüche, **dadurch gekennzeichnet, daß** die Substrat-Behandlungseinrichtung ein Substrattrockner oder -kühler (11, 12, 13) ist.

## Claims

1. Device for moving substrates (7) through substrate treatment equipment (11) comprising a base transport belt (2) and two lateral transport belts (4, 6) which have respective incisions for vertical reception of the substrates (7) **characterised in that** the spacing of the lateral transport belts (4, 6) relative to one another and/or to the base transport belt (2) is variable and that the angle between the transport plane of at least one lateral transport belt (4, 6) and the transport plane of the base transport belt (2) is variable.

2. Device according to claim 1, **characterised in that** the incisions are intermediate spaces of transport belts (2, 4, 6) constructed as cogged belts.

3. Device according to one of the preceding claims, **characterised in that** the transport plane of the two lateral transport belts (4, 6) can be set to an angle greater than 90° to the transport plane of the base transport belt (2).

4. Device according to one of the preceding claims, **characterised in that** the transport belts are guided over respective deflecting and drive wheels or rollers.

5. Device according to one of the preceding claims, **characterised in that** each of the three transport belts (2, 4, 6) is guided in an own transport belt unit (1, 3, 5) and driven by an own drive.

6. Device according to claim 5, **characterised in that** the drives of the three transport belt units (2, 4, 6) are controlled synchronously relative to one another.

7. Device according to claim 5, **characterised in that** the drives of the three transport belt units (1, 3, 5) are connected with a common drive (10).

8. Device according to one of the preceding claims, **characterised in that** at least the parts of the transport belts (2, 4, 6) coming into contact with the substrates (7) consist of Teflon.

9. Device according to one of the preceding claims, **characterised in that** at least one suction gripper for loading and/or unloading the substrates (7) is provided.

10. Device according to one of the preceding claims, **characterised in that** at least one gripper, which grips at the edge of an inner aperture of substrates, for loading and/or unloading the substrates (7) is provided.

11. Device according to one of the preceding claims, **characterised in that** the substrate treatment equipment is a substrate drier or substrate cooler (11, 12, 13).

## Revendications

1. Dispositif pour faire passer des substrats (7) à travers une installation de traitement de substrats (11) avec une bande de transport de base (2) et deux bandes de transport latérales (4, 6) qui présentent respectivement des entailles pour la réception verticale des substrats (7), **caractérisé en ce que** l'écart des bandes de transport latérales (4, 6) l'une à l'autre et/ou à la bande de transport de base (2) est modifiable, et **en ce que** l'angle entre le plan de transport d'au moins une bande de transport latérale (4, 6) et le plan de transport de la bande de transport de base (2) est modifiable.

2. Dispositif selon la revendication 1, **caractérisé en ce que** les entailles sont des espaces intermédiaires de bandes de transport (2, 4, 6) réalisées sous forme de courroies dentées.

3. Dispositif selon l'une des revendications précédentes, **caractérisé en ce que** le plan de transport des deux bandes de transport latérales (4, 6) peut être réglé à un angle plus grand que 90° relativement au plan de transport de la bande de transport de base (2).

4. Dispositif selon l'une des revendications précédentes, **caractérisé en ce que** les bandes de transport sont guidées respectivement sur des roues ou rouleaux de renvoi et d'entraînement.

5. Dispositif selon l'une des revendications précédentes, **caractérisé en ce que** chacun des trois bandes de transport (2, 4, 6) est guidée dans une unité de bande de transport propre (1, 3, 5) et est entraînée par un dispositif d'entraînement propre.

6. Dispositif selon la revendication 5, **caractérisé en ce que** les dispositifs d'entraînement des trois unités de bande de transport (2, 4, 6) sont commandés d'une manière synchrone les uns avec les autres.

7. Dispositif selon la revendication 5, **caractérisé en ce que** les dispositifs d'entraînement des trois unités de bande de transport (1, 3, 5) sont reliés par un mécanisme de transmission commun (10).

8. Dispositif selon l'une des revendications précédentes, **caractérisé en ce qu'**au moins les parties des bandes de transport (2, 4, 6) qui viennent en contact avec les substrats (7) sont en Teflon.

9. Dispositif selon l'une des revendications précédentes, **caractérisé en ce qu'**il est prévu au moins une griffe aspirante pour charger et/ou décharger les substrats (7).

10. Dispositif selon l'une des revendications précédentes, **caractérisé en ce qu'**il est prévu au moins une griffe s'appliquant au bord d'un trou intérieur de substrats pour le chargement et/ou le déchargement des substrats (7).

11. Dispositif selon l'une des revendications précédentes, **caractérisé en ce que** l'installation de traitement des substrats est un séchoir ou refroidisseur de substrats (11, 12, 13).
